Europäisches Patentamt

European Patent Office

Office européen des brevets

(11) Veröffentlichungsnummer: **0 361 265**
**A1**

(12) **EUROPÄISCHE PATENTANMELDUNG**

(21) Anmeldenummer: 89117242.1

(22) Anmeldetag: 18.09.89

(51) Int. Cl.⁵: **C04B 35/00 , H01L 39/24 , C23C 14/08**

(30) Priorität: 29.09.88 DE 3833132

(43) Veröffentlichungstag der Anmeldung:
04.04.90 Patentblatt 90/14

(84) Benannte Vertragsstaaten:
**AT BE CH DE ES FR GB IT LI NL SE**

(71) Anmelder: **Siemens Aktiengesellschaft**
**Wittelsbacherplatz 2**
**D-8000 München 2(DE)**

(72) Erfinder: **Freller, Helmut**
**Steinbergstrasse 34A**
**D-8505 Röthenbach(DE)**
Erfinder: **Schack, Peter**
**Schnieglinger Strasse 33**
**D-8500 Nürnberg(DE)**

(54) **Herstellung von dünnen Schichten eines Hochtemperatur-Supraleiters (HTSL) durch ein plasmaaktiviertes PVD-Verfahren und dabei verwendete Kathoden.**

(57) Beim erfindungsgemäßen Verfahren wird in einem kathodischen Lichtbogenverdampfungsprozeß Material von einer Kathode abgedampft und auf einem Substrat abgeschieden, wobei der Lichtbogenfußpunkt regellos oder gesteuert auf der Kathodenoberfläche bewegt wird. Vorzugsweise werden beim Lichtbogenverdampfungsprozeß wenigstens zwei Kathoden aus unterschiedlichen Legierungen bzw. Mischungen der metallischen Komponenten des Hochtemperatur-Supraleiters (HTSL) von jeweils einem Lichtbogen zur Verdampfung aktiviert und werden die aus den unterschiedlichen Legierungen abgedampften Materialien gemeinsam auf dem Substrat abgeschieden, wobei der Lichtbogenverdampfungsprozeß reaktiv unter Sauerstoffatmosphäre vorgegebenen $O_2$-Partialdruckes erfolgt. Eine Wärmebehandlung zur Einstellung der für die Supraleitung geeigneten Struktur und Sauerstoffstöchiometrie kann anschließend und/oder bereits beim Aufdampfprozeß durchgeführt werden.

FIG 1

EP 0 361 265 A1

## Herstellung von dünnen Schichten eines Hochtemperatur-Supraleiters (HTSL) durch ein plasmaakti- viertes PVD-Verfahren und dabei verwendete Kathoden

Die Erfindung bezieht sich auf die Herstellung von dünnen Schichten eines Hochtemperatur-Supraleiters (HTSL) durch ein plasmaaktiviertes PVD-Verfahren, bei dem in einem kathodischen Prozeß Material von einer Kathode abgetragen und auf einem Substrat abgeschieden wird und bei dem durch eine Wärmebehandlung eine für die Supraleitung geeignete Struktur und Sauerstoffstöchiometrie eingestellt wird. Weiterhin bezieht sich die Erfindung auf die zur Herstellung der Schichten verwendeten Kathoden.

Für die Realisierung von Hochtemperatur-Supraleitern (HTSL) mit hoher Stromtragfähigkeit müssen nach derzeitigen Kenntnissen diese keramischen Werkstoffe in bestimmten Vorzugsorientierungen der Feinstruktur vorliegen. Bisher ist es nur über Verfahren der Abscheidung über die Gasphase gelungen, dünne Schichten mit derartiger Ordnung herzustellen. Als Substrate fanden dabei vorwiegend Zirkondioxid ($ZrO_2$), Magnesiumoxid (MgO), Strontiumtitanat ($SrTiO_3$) und andere Werkstoffe mit angepaßten Ausdehnungskoeffizienten und Gitterstruktur Verwendung. Auf entsprechend orientierten Einkristalloberflächen dieser Substratwerkstoffe ist ein epitaxiales Wachstum des HTSL-Materials möglich.

Die Herstellung solcher dünner vorzugsorientierter Schichten der unterschiedlichen, bisher bekannten HTSL-Materialien, wie z. B. Y-Ba-Cu-O oder Bi-Sr-Ca-Cu-O oder Tl-Ba-Ca-Cu-O (jeweils ohne Angabe der Stöchiometrie), erfolgte bisher einerseits durch konventionelle Verfahren der PVD-Technik (physical vapour deposition), wie z. B. durch Kathodenzerstäubung von gesinterten HTSL-Targets mit Hilfe von Gleichspannungs-, Hochfrequenz- und Magnetron-Verfahren. Andererseits gelang auch durch Verdampfen der Einzelelemente aus getrennten Tiegeln in einer Sauerstoffatmosphäre sowie durch Verdampfung von HTSL-Targets mit Hilfe von Excimer-Laserimpulsen die Herstellung vorzugsorientierter Schichten mit hoher Stromtragfähigkeit.

Zur Herstellung der orientierten Materialien mit tragbarem wirtschaftlichen Aufwand ist wesentliche Vorbedingung eine hinreichend große Aufwachsrate. Letztere ist bei den bisherigen PVD-Verfahren so gering, daß nur spezifische Anwendungen in der Mikroelektronik in Frage kommen. Lediglich beim Laserverdampfen werden solche Aufwachsraten erreicht, wie sie in der Praxis gefordert werden.

Aufgabe der Erfindung ist es daher, ein weiteres Verfahren zur Herstellung von HTSL-Schichten anzugeben, mit dem ähnlich hohe Aufwachsraten wie beim Laserverdampfen erreicht werden. Außerdem sollen die dabei zur Anwendung kommenden Kathoden geschaffen werden.

Die Aufgabe ist erfindungsgemäß dadurch gelöst, daß ein Lichtbogenverdampfungsprozeß angewandt wird, bei dem der Lichtbogenfußpunkt regellos oder gesteuert auf der Kathodenboberfläche bewegt wird. Vorzugsweise werden beim Lichtbogenverdampfungs prozeß wenigstens zwei Kathoden aus unterschiedlichen Legierungen bzw. Mischungen der metallischen Komponenten des Hochtemperatur-Supraleiters (HTSL) von jeweils einem Lichtbogen zur Verdampfung aktiviert und werden die aus den unterschiedlichen Legierungen abgedampften Materialien gemeinsam auf dem Substrat abgeschieden, wobei der Lichtbogenverdampfungsprozeß reaktiv unter Sauerstoff-Atmosphäre vorgegebenen $O_2$-Partialdruckes erfolgt.

Durch die Erfindung ist es also möglich, zur Herstellung von dünnen Schichten oxidischer Hochtemperatur-Supraleiter von metallischen Legierungen der Ausgangselemente auszugehen. Dabei sind typische Ausgangslegierungen beispielsweise die Zweistoffsysteme Y-Cu und Ba-Cu zur Herstellung von Y-Ba-Cu-O-Schichten. Entsprechend können die Zweistoffsysteme Bi-Sr bzw. Cu-Ca oder auch die Dreistoffsysteme Bi-Cu-Sr oder Bi-Cu-Ca zur Herstellung von Bi-Sr-Ca-Cu-O-Schichten verwendet werden. Dementsprechend ist es auch möglich zur Herstellung von Tl-Ba-Ca-Cu-O-Schichten entweder von Zweistoffsystemen Tl-Ba und Cu-Ca oder auch von Dreistoffsystemen Tl-Ba-Cu und Tl-Cu-Ca auszugehen.

Erfindungsgemäß hat zur Herstellung von Y-Ba-Cu-O-Schichten die Kathode aus Yttrium-Kupfer eine Zusammensetzung zwischen 40:60 und 60:40 und die Kathode aus Barium-Kupfer eine Zusammensetzung 40:60 und 70:30. Beide Legierungskathoden können vorzugsweise eine Zusammensetzung von je 50:50 haben.

Zur Herstellung von Bi-Sr-Ca-Cu-Schichten hat die Kathode aus Wismut-Strontium eine Zusammensetzung zwischen 40:60 und 60:40 und die Kathode aus Calcium-Kupfer eine Zusammensetzung zwischen 80:20 und 50:50. Die Bi-Sr-Legierungskathode kann vorzugsweise eine Zusammensetzung von 50:50 und die Ca-Cu-Legierungskathode eine Zusammensetzung von 66:34 haben. Wenn dagegen eine erste Kathode aus Wismut-Kupfer-Strontium und eine zweite Kathode aus Wismut-Kupfer-Calcium verwendet wird, haben beide Legierungskathoden eine Zusammensetzung zwischen 15:70:15 und 25:50:25. Dabei kann bei den wismuthaltigen Legierungskathoden vorteilhafterweise ein Teil des Wismuts jeweils durch Blei ersetzt werden.

Gegebenenfalls können für die Herstellung von Schichten der beiden letztgenannten Hochtemperatur-Supraleiter (HTSL) auch drei Kathoden als Verdampfer verwendet werden. Die Zusammensetzung der Einzelkathoden ist dabei immer so zu wählen, daß in der Summe alle Metalle der zu synthetisierenden HTSL-Verbindung enthalten sind und durch richtige Wahl der Verdampferströme die erforderliche Stöchiometrie der Einzelkomponenten in der Schicht eingestellt werden kann. Dabei ist in allen Fällen vorteilhaft, daß die Legierungskathoden leichter zu handhaben sind als die sehr reaktionsfreudigen Metalle wie insbesondere Yttrium und Barium.

Bei der Erfindung kann die Temperaturführung derart erfolgen, daß sich in bekannter Weise eine Wärmebehandlung der Schicht unter Luft oder Sauerstoff an den eigentlich Verdampfungsprozeß anschließt. Das Substrat kann sich aber auch bereits während des Verdampfungsprozesses auf einer entsprechend hohen Temperatur befinden. Weiterhin kann an das Substrat während des Verdampfungsprozesses eine variable Saugspannung angelegt werden.

Der kathodische Lichtbogenverdampfungsprozeß wird bisher vorwiegend zur Beschichtung von Werkstücken mit funktionellen Hartstoffschichten angewandt, wozu auf Veröffentlichungen in der Fachliteratur verwiesen wird (z.B. Thin Solid Films 153 (1987), 67 - 74 und Annals of the CIRP Vol 37/1/1988). Als Quellen für den Lichtbogenverdampfungsprozeß kommen Reinmetalle oder Legierungen in Frage. Wegen der hohen Leistungsdichte ergibt sich vorteilhafterweise immer eine große Aufwachsrate.

Weitere Einzelheiten und Vorteile der Erfindung ergeben sich aus der nachfolgenden Beschreibung eines Ausführungsbeispiels anhand der Zeichnung in Verbindung mit den weiteren Unteransprüchen. Es zeigen

FIG 1 in schematischer Darstellung die verwendete Beschichtungsanlage sowie die

FIG 2 und FIG 3 experimentelle Ergebnisse von in der Anlage gemäß FIG 1 aufgedampften Schichten.

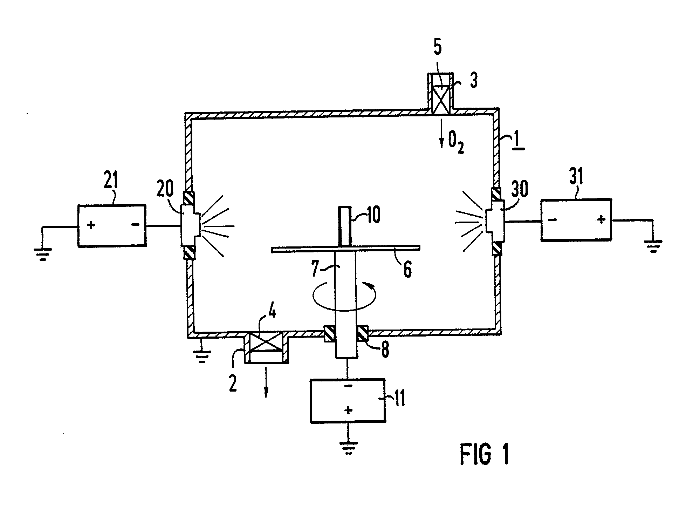

In FIG 1 ist ein metallischer Rezipient mit 1 bezeichnet, der einen großvolumigen Auslaß 2, der zu einer (nicht dargestellten) Vakuumpumpe führt, und eine kleinvolumige Zuleitung 3 zur Zuführung von Reaktionsgasen hat, womit beispielsweise ein vorgegebener Sauerstoffpartialdruck eingestellt werden kann. Auslaß 2 und Zuleitung 3 haben jeweils ein entsprechendes Ventil 4 bzw. 5, wobei speziell Ventil 5 als Dosierventil ausgebildet ist.

In die metallische Wand des Rezipienten 1 sind einander gegenüberliegend isoliert zwei Kathoden 20 und 30 aus unterschiedlichen Materialien, insbesondere Legierungen eingesetzt. Jede der Kathoden 20 bis 30 befindet sich gegenüber dem metallischen Gehäuse des Rezipienten 1 auf negativem Potential, das durch eine Spannungsquelle 11 bzw. 21 zwischen -15 und -40 V vorgebbar ist. Damit definiert die metallische Wandung des Rezipienten 1 eine Anode, wobei sich zwischen Anode und Legierungskathode jeweils ein Lichtbogen ausbildet, der in bekannter Weise durch eine Zündelektrode aktiviert wird. Der Lichtbogen bewegt sich je nach Ausführungsform der Kathoden regellos oder gesteuert auf der Kathodenoberfläche und bildet auf dem Legierungsmaterial einen oder mehrere Fußpunkte, so daß dort das Material zur Verdampfung aktiviert wird. Durch die geringe Verweilzeit des bzw. der Lichtbogenfußpunkte an einer Stelle der Kathode und die hohe Energiedichte des Lichtbogens werden jeweils kleinste Materialmengen blitzartig verdampft.

Zwischen den beiden Kathoden 20 und 30 befindet sich symmetrisch angeordnet ein Substrat 10 auf dem Träger 6 einer Drehhalterung 7, die eine Drehdurchführung 8 durch den Rezipienten 1 hat. An das Substrat 10 ist über eine Spannungsquelle 11 eine negative Vorspannung zwischen 0 und 1000 V anlegbar.

Wenn die Legierungskathoden durch den jeweiligen Lichtbogen zur Verdampfung aktiviert werden, entstehen Teilchenströme in Richtung auf das Substrat 10, die in FIG 1 durch die unterschiedlichen Pfeilrichtungen angedeutet sind. Damit beide Teilchenströme das Substrat 10 gleichmäßig beaufschlagen, wird der Substrathalter 7 in Rotation versetzt. Alternativ dazu kann ein Rezipient mit Kathoden derart aufgebaut sein, daß auch ohne Drehung beide oder mehrere Teilchenströme gleichzeitig auf das Substrat 10 gelenkt werden können.

Dem Substratträger 6 kann eine Heizvorrichtung für das Substrat 10 zugeordnet sein, mit der das Substrat 10 auf eine vorgebbare Temperatur erwärmbar ist. Eine solche Heizeinrichtung, die in FIG 1 nicht dargestellt ist, kann insbesondere als Strahlungsheizung wirken.

Bei der gemäß FIG 1 beschriebenen Vorrichtung können auch mehr als zwei Kathoden vorhanden sein. Es lassen sich somit unterschiedliche Verdampfer verschiedener Konzentration vorgeben, wobei die Teilchenströme durch die an der Kathode angelegte Spannung variiert werden können. Weiterhin läßt sich nach Evakuierung ein Reaktionsgas in den Rezipienten 1 einleiten, so daß die Verdampfung reaktiv erfolgt. Insbesondere ist für den bestimmungsgemäßen Zweck ein vorgebbarer Sauerstoffpartialdruck erwünscht.

In einer Vorrichtung gemäß FIG 1 lassen sich auf dem Substrat 10 dünne Schichten eines Hochtemperatur-Supraleiters (HTSL) abscheiden, wenn Legierungskathoden entsprechender Zusammensetzung und geeignete Randbedingungen beim Verdampfen gewählt werden. Hochtemperatur-Supraleiter

3

(HTSL) mit Sprungtemperaturen oberhalb des Siedepunktes von flüssigem Stickstoff (77K) sind derzeit auf Yttrium-, Wismut- und Thallium-Basis bekannt und als Beispiele in Tabelle 1 mit ihrer entsprechenden Stöchiometrie zusammengestellt.

Im Beispiel 1 ergibt sich, daß zum Erreichen der supraleitenden Phase der Stöchiometrie $YBa_2Cu_3O_{7-\delta}$ zwei Legierungskathoden mit einer Kathode aus Yttrium-Kupfer und der anderen Kathode aus Barium-Kupfer gewählt werden sollten. Bei den weiteren Beispielen, bei denen der Hochtemperatur-Supraleiter jeweils wenigstens vier metallische Komponenten hat, sind unterschiedliche Möglichkeiten für Zahl und Art der Legierungskathoden denkbar, wobei es sinnvoll sein kann, drei Kathoden zu verwenden.

Im Rahmen der der Erfindung zugrundeliegenden Arbeiten wurde Beispiel 1 im einzelnen untersucht. Dabei wurde für die Legierungskathode aus YCu eine Konzentration in Massenanteilen von 50:50 und für die Legierungskathode aus BaCu eine Konzentration in Massenanteilen von 64:36 gewählt.

In der Vorrichtung gemäß FIG 1 wurde in einer Sauerstoffatmosphäre mit einem $O_2$-Partialdruck von 2 Pascal gearbeitet. Bei richtiger Wahl der Verdampferströme entstand auf dem Substrat 10, das sich abwechselnd den beiden Quellen zuwendet, eine HTSL-Schicht, die anschließend zusätzlich unter Sauerstoff bei einer Temperatur von 900°C getempert wurde. Alternativ kann bei Abscheidung auf einem geheizten Substrat bereits bei Abkühlen in Sauerstoffatmosphäre der für die Einstellung einer für die Hochtemperatur-Supraleitung geeigneten Stöchiometrie erforderliche Sauerstoff aufgenommen werden.

Es wurden auf Zirkonoxid vorzugsorientierte Schichten mit einer Dicke von 1 bis 1,5 μm hergestellt. Aufgrund der hohen Energiedichte beim Lichtbogenverdampfen ergeben sich Aufwachsraten in der Größenordnung von 1 bis 2 nm pro Sekunde, so daß derartige Schichtdicken in weniger als einer Stunde, beispielsweise in 30 Minuten, herstellbar sind. Die supraleitenden Schichten haben eine Sprungtemperatur von $T_c = 90K$.

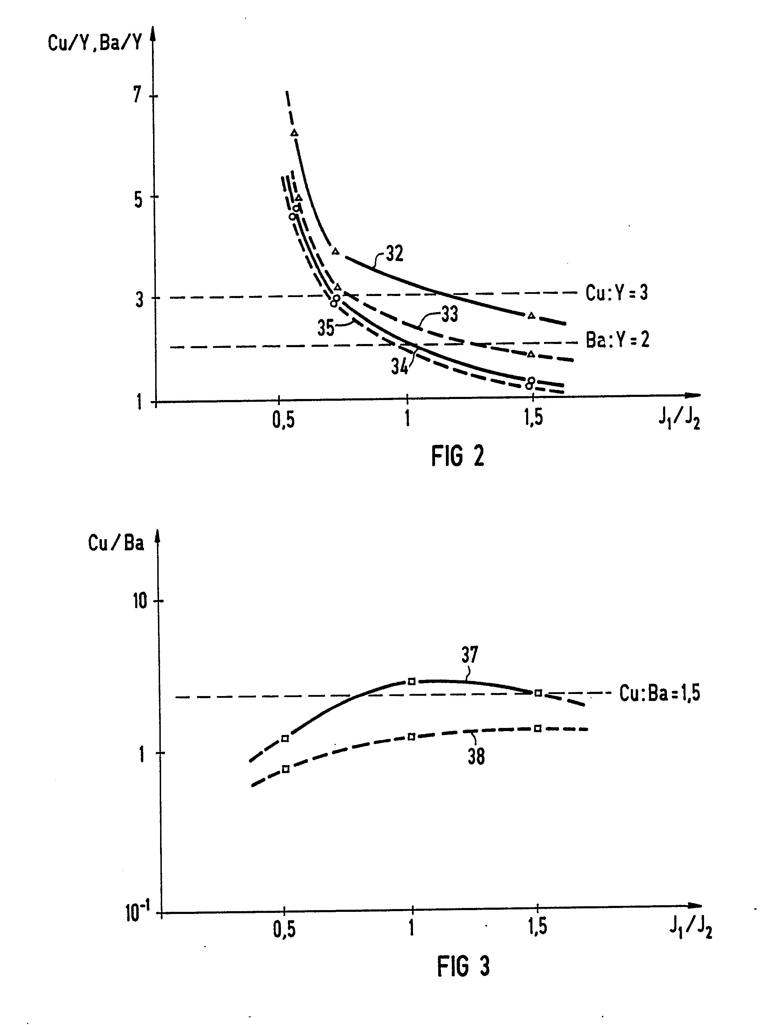

In Versuchsreihen wurde der Einfluß der Verdampferströme auf die Konzentration der Legierungsbestandteile in der erzeugten Schicht ermittelt, was in den Diagrammen gemäß FIG 2 und 3 wiedergegeben ist. Die Diagramme stellen die Ergebnisse einer ICP-Analyse (inductive conpled plasma) an fertigen HTSL-Schichten dar, wobei jeweils das Verhältnis zweier Elemente der drei metallischen Komponenten Yttrium, Barium, Kupfer des $YBa_2Cu_3O_{7-\delta}$-Supraleiters als Funktion des Verhältnisses der elektrischen Ströme an den Legierungskathoden dargestellt ist.

In FIG 3 ist auf der Abszisse das Verhältnis von $I_1$ zu $I_2$ aufgetragen, wobei bei den experimentellen Untersuchungen an der Legierungskathode 20 aus YCu50 der Strom $I_1 \hat{=}$ const. = 60 A gehalten wurde und an der Legierungskathode 30 aus BaCu36 der Strom $I_2$ variiert wurde. Auf der Ordinate ist in FIG 2 das Verhältnis Cu/Y und Ba/Y linear und in FIG 3 das Verhältnis Ca/Ba logarithmisch dargestellt. Die Soll-Größen für die Stöchiometrie sind als Parallelen zur Abszisse jeweils eingetragen.

In FIG 2 bedeutet die Kurve 32 die Konzentration Cu:Y im ungetemperten Zustand der Schicht und die Kurve 33 die entsprechende Konzentration im getemperten Zustand der Schicht. Die Kurve 34 bedeutet die Konzentration Ba:Y im ungetemperten Zustand der Schicht und die Kurve 35 die entsprechende Konzentration im getemperten Zustand der Schicht. In FIG 3 bedeutet die Kurve 37 die Konzentration Cu:Ba im ungetemperten Zustand und die Kurve 38 die entsprechende Konzentration im getemperten Zustand der Schicht.

Eine Bewertung der Untersuchungsergebnisse zeigt, daß die Schichtzusammensetzung im Hinblick auf die Elementverhältnisse Y:Cu, Ba:Y und Cu:Ba durch eine Variation im Verhältnis der Verdampferströme $I_1$ und $I_2$ der beiden Kathoden ge zielt beeinflußt werden kann. Dadurch können bei entsprechenden Kathodenzusammensetzungen die vorgegebenen Soll-Werte erreicht werden. Es ergibt sich, daß hierfür die Legierungszusammensetzung in der ersten Legierungskathode aus BaCu auf 50:50 angehoben werden sollte.

Entsprechende Überlegungen lassen sich für die weiteren zwischenzeitlich bekanntgewordenen Hochtemperatur-Supraleiter auf der Basis von Wismut einerseits und Thallium andererseits durchführen. Speziell das Wismut kann dabei auch teilweise durch Blei substituiert werden.

Bei dem beschriebenen Verfahren ist systembedingt die Leistungsdichte an der Materialquelle günstig; dadurch sind für die HTSL-Schichten so hohe Aufwachsraten erzielbar, wie sie bisher nur durch Laser-Impulsverdampfen zu erreichen waren. Die Tabelle 2 gibt hierzu einen aktuellen Vergleich mit anderen Verfahren zur Herstellung von HTSL-Schichten. Gegenübergestellt ist die herkömmliche Kathodenzerstäubung, die mit Hochfrequenz oder einem Magnetron erfolgen kann, mit der allgemein als vorteilhaft erachteten Laserverdampfung und der erfindungsgemäßen Lichtbogenverdampfung.

Während bei den beiden in der Tabelle 2 erstgenannten Verfahren als Quellen vorher eigens hergestelltes HTSL-Material verwendet wird, können beim erfindungsgemäßen Verfahren Metalle und insbesondere Legierungen als Kathoden Anwendung finden. Durch Vorgabe der Lichtbogenströme kann die geeignete Zusammensetzung der HTSL-Schicht "in situ" erreicht werden.

4

Für das Laser- und das Lichtbogenverdampfen ergibt sich gleichermaßen eine erheblich höhere Leistungsdichte als bei der Kathodenzerstäubung. Die sich daraus speziell beim Lichtbogen verdampfen ergebende Aufwachsrate von ca. 1,4 nm/s kann über den Aufwachsraten beim Laserverdampfen, das im Impulsbetrieb erfolgt und insofern noch von der Impulsfrequenz abhängig ist, liegen.

Tabelle 1

| Verwendung unterschiedlicher Legierungen zur Herstellung von HTSL-Schichten | | | |
|---|---|---|---|
| HTSL | $T_c$ | Legierungs-Kathode 1 | Legierungs-Kathode 2 |
| 1. $Y_1Ba_2Cu_3O_{7-\delta}$ | 90 K | YCu 40:60-70:30 | BaCu 40:60-60:40 |
| 2. $Bi_2Sr_2Ca_{n-1}Cu_nO_x$ — | | BiSr 40:60-60:40 BiCuSr 15:70:15-25:50:25 | CaCu 20:80-40:60 BiCuCa 15:70:15-25:50:25 |
| n = 2: $Bi_2Sr_2Ca_1Cu_2O_x$ | 80K | (Bi kann teilweise durch Pb ersetzt werden) | |
| n = 3: $Bi_2Sr_2Ca_2Cu_3O_x$ | 110K | | |
| 3. $Tl_2Ba_2Ca_{n-1}Cu_nO_y$ — | | TlBa TlCuBa | CaCu TlCuCa |
| n = 2: $Tl_2Ba_2Ca_1Cu_2O_y$ | 105K | | |
| n = 3: $Tl_2Ba_2Ca_2Cu_3O_y$ | 125K | | |

Tabelle 2

| Vergleich verschiedener PVD-Verfahren zur Herstellung von HTSL-Schichten | | | | |
|---|---|---|---|---|
| | Kathodenzerstäubung | | Laserimpulsverdampfung | Lichtbogenverdampfung |
| | HF | Magnetron | | |
| Quellenmaterial | HTSL | HTSL | HTSL | Metalle, Legierungen |
| Leistungsdichte (W/cm²) | 2,3 | 4 | $3.10^7$ | $2.10^7$ |
| Aufwachsrate (nm/s) | 0,1 | 0,3 | *) 0,25-1,7 ***) | 1,4 |
| | | | *) Impulsfrequenz 1Hz, KrF | |
| | | | ***) Impulsfrequenz 5 Hz, XeCl | |

**Ansprüche**

1. Plasmaaktiviertes PVD-Verfahren zur Herstellung von dünnen Schichten eines Hochtemperatur-Supraleiters (HTSL), bei dem in einem kathodischen Prozeß Material von einer Kathode abgetragen und auf einem Substrat abgeschieden wird und bei dem durch eine Wärmebehandlung eine für die Supraleitung geeignete Struktur und Sauerstoffstöchiometrie eingestellt wird, **dadurch gekennzeichnet,** daß ein Lichtbogenverdampfungsprozeß angewandt wird, bei dem der Lichtbogenfußpunkt regellos oder gesteuert auf der Kathodenoberfläche bewegt wird.

2. Verfahren nach Anspruch 1, **dadurch gekennzeichnet,** daß beim Lichtbogenverdampfungsprozeß wenigstens zwei Kathoden aus unterschiedlichen Legierungen bzw. Mischungen der metallischen Komponenten des HochtemperaturSupraleiters (HTSL) von jeweils einem Lichtbogen zur Verdampfung aktiviert werden und daß die aus den unterschiedlichen Legierungen abgedampften Materialien gemeinsam auf dem Substrat abgeschieden werden, wobei der Lichtbogenverdampfungsprozeß reaktiv unter Sauerstoff-Atmo-sphäre vorgegebenen $O_2$-Partialdruckes erfolgt.

3. Verfahren nach Anspruch 2, **dadurch gekennzeichnet,** daß der Sauerstoff-Partialdruck zwischen

$10^{-2}$ und $10^{-1}$Pa, vorzugsweise bei $2\times10^{-2}$Pa, liegt.

4. Verfahren nach Anspruch 1, **dadurch gekennzeichnet**, daß das Substrat geheizt wird, vorzugsweise auf eine Temperatur >500° C.

5. Verfahren nach Anspruch 1, **dadurch gekennzeichnet**, daß das Substrat zwischen den Kathoden aus den unterschiedlichen Legierungen symmetrisch angeordnet ist und periodisch gedreht wird.

6. Verfahren nach Anspruch 1, **dadurch gekennzeichnet**, daß an das Substrat eine variable Saugspannung, vorzugsweise zwischen 0 und 1000 V anlegbar ist.

7. Verfahren nach Anspruch 1 oder einem der Ansprüche 2 bis 6, zur Herstellung von Y-Ba-Cu-O-Schichten, **dadurch gekennzeichnet**, daß eine erste Kathode aus Barium-Kupfer und eine zweite Kathode aus Yttrium-Kuper verwendet wird.

8. Verfahren nach Anspruch 1 oder einem der Ansprüche 2 bis 6, zur Herstellung von Bi-Sr-Ca-Cu-O-Schichten, **dadurch gekennzeichnet**, daß eine erste Kathode aus Wismut-Strontium und eine zweite Kathode aus Kupfer-Kalzium verwendet wird.

9. Verfahren nach Anspruch 1 oder einem der Ansprüche 2 bis 6, zur Herstellung von Bi-Sr-Ca-Cu-O-Schichten, **dadurch gekennzeichnet**, daß eine erste Kathode aus einer Wismut-Kupfer-Strontium-Legierung und eine zweite Kathode aus einer Wismut-Kupfer-Kalzium-Legierung verwendet wird.

10. Verfahren nach Anspruch 1 oder einem der Ansprüche 2 bis 6, zur Herstellung von Tl-Ba-Ca-Cu-O-Schichten, **dadurch gekennzeichnet**, daß eine erste Kathode aus einer Thallium-Barium- oder Thallium-Kupfer-Barium-Legierung und eine zweite Kathode aus einer Kupfer-Kalzium- oder Thallium-Kupfer-Kalzium-Legierung verwendet wird.

11. Kathode zur Verwendung bei einem Verfahren nach Anspruch 7, **dadurch gekennzeichnet**, daß die erste Ka thode aus Barium-Kupfer eine Zusammensetzung zwischen 40:60 und 70:30, vorzugsweise bei 50:50, hat.

12. Kathode zur Verwendung bei einem Verfahren nach Anspruch 7, **dadurch gekennzeichnet**, daß die zweite Kathode aus Yttrium-Kupfer eine Zusammensetzung zwischen 40:60 und 60:40, vorzugsweise bei 50:50, hat.

13. Kathode zur Verwendung bei einem Verfahren nach Anspruch 10, **dadurch gekennzeichnet**, daß die erste Kathode aus Wismut-Strontium eine Zusammensetzung zwischen 40:60 und 60:40, vorzugsweise bei 50:50, ht.

14. Kathode zur Verwendung bei einem Verfahren nach Anspruch 10, **dadurch gekennzeichnet**, daß die zweite Kathode aus Kupfer-Kalzium eine Zusammensetzung zwischen 80:20 und 50:50, vorzugsweise bei 66:34, hat.

15. Kathode zur Verwendung bei einem Verfahren nach Anspruch 13, **dadurch gekennzeichnet**, daß die erste Kathode aus Wismut-Kupfer-Strontium eine Zusammensetzung zwischen 15:70:15 und 30:40:30, vorzugsweise bei 25:50:25, hat.

16. Kathode zur Verwendung bei einem Verfahren nach Anspruch 13, **dadurch gekennzeichnet**, daß die zweite Kathode aus Wismut-Kupfer-Kalzium eine Zusammensetzung zwischen 15:70:15 und 30:40:30, vorzugsweise bei 25:50:25, hat.

17. Kathode nach einem oder mehreren Ansprüchen 13, 15 oder 16, **dadurch gekennzeichnet**, daß in der ersten Kathode und/oder zweiten Kathode das Wismut teilweise durch Blei substituiert ist.

3432

FIG 1

3432

FIG 2

FIG 3

Europäisches
Patentamt

**EUROPÄISCHER RECHERCHENBERICHT**

Nummer der Anmeldung

EP 89 11 7242

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 284 489 (SUMITOMO ELECTRIC IND. LTD) <br> * Ansprüche 1-7,13-25 * | 1-4 | C 04 B 35/00 <br> H 01 L 39/24 <br> C 23 C 14/08 |
| A | --- | 5-17 | |
| Y | US-A-4 654 231 (G.A. NYBER et al.) <br> * Anspruch 1, Spalte 1, Zeilen 40-55 * <br> --- | 1-4 | |
| Y | EP-A-0 107 325 (WESTERN ELECTRIC CO. INC.) <br> * Ansprüche 1-10; Seite 2, Zeilen 5-30; Seite 4, Zeilen 2-10 * <br> --- | 1-4 | |
| A | DE-A-3 627 151 (LEYBOLD-HERAEUS GmbH) <br> * Ansprüche 1-3; Spalte 2, Zeilen 30-47 * <br> ----- | 1-6 | |

RECHERCHIERTE SACHGEBIETE (Int. Cl.5)

C 04 B
H 01 L
C 23 C

Der vorliegende Recherchenbericht wurde für alle Patentansprüche erstellt

| Recherchenort | Abschlußdatum der Recherche | Prüfer |
|---|---|---|
| DEN HAAG | 17-11-1989 | LUETHE H. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
..............................................................................
& : Mitglied der gleichen Patentfamilie, übereinstimmendes
    Dokument

EPO FORM 1503 03.82 (P0403)